# FASCICULE DE BREVET EUROPEEN

(11) **EP 2 936 601 B1**
(45) Date de publication et mention de la délivrance du brevet: **13.11.2019**
(21) Numéro de dépôt: 13802670.3
(22) Date de dépôt: 11.12.2013
(51) Int. Cl.: H01M 16/00, H01M 8/2475, H01M 8/04029, H01M 8/04007, H01M 8/04225

(54) **SYSTÈME DE PRODUCTION D'ÉNERGIE ÉLECTRIQUE À PILE À COMBUSTIBLE**
KRAFTERZEUGUNGSSYSTEM MIT EINER BRENNSTOFFZELLE
POWER-GENERATING SYSTEM HAVING A FUEL CELL

(30) Priorité: 24.12.2012 FR 1262761
(43) Date de publication de la demande: 28.10.2015
(73) Titulaire: Areva Stockage d'Energie, 13547 Aix-en-Provence Cedex 4 (FR)
(72) Inventeur: CHAUDRON, Valery, F-04100 Manosque (FR)
(74) Mandataire: Lavoix
(86) Numéro de dépôt international: PCT/EP2013/076293
(87) Numéro de publication internationale: WO 2014/102064

(56) Documents cités:
- EP-A1- 1 482 254
- JP-A- H0 822 832
- JP-A- H1 064 561
- JP-A- 2003 151 595
- JP-A- 2006 147 315
- JP-A- 2007 134 241
- JP-A- 2010 272 462
- US-A1- 2006 003 193

## Description

La présente invention concerne les systèmes de production d'énergie électrique comprenant une pile à combustible produisant de l'énergie électrique par oxydoréduction d'un combustible et d'un comburant.

De tels systèmes de production d'énergie électrique sont utilisés comme source d'énergie électrique de secours en cas de défaillance d'un réseau électrique, pour alimenter en énergie électrique des bâtiments ou des installations sensibles nécessitant un fonctionnement continu au moins de certains de leurs équipements, tels qu'un hôpital ou une centrale nucléaire. Une défaillance du réseau électrique peut être due par exemple à une catastrophe naturelle, telle qu'une inondation, un tremblement de terre, un événement météorologique (cyclone, typhon, tornade...).

De tels systèmes de production d'énergie électrique sont généralement dimensionnés pour fournir une alimentation électrique de secours sur une période longue allant de plusieurs heures à plusieurs jours.

De tels systèmes de production d'énergie électrique sont inactifs pendant de longues périodes. L'environnement dans lequel ils doivent fonctionner n'est pas connu à l'avance (température, pollution atmosphérique, irradiations, inondation...)

JP2010272462A divulgue un système de production d'énergie électrique comprenant une pile à combustible disposée à l'intérieur d'une enceinte et un système de régulation thermique.

US2006003193A1 décrit un système de production d'énergie électrique comprenant une pile à combustible et un dispositif de stockage d'énergie électrique

Il est souhaitable qu'un tel système de production d'énergie électrique puisse démarrer et fonctionner de manière fiable quel que soit l'environnement instantané dans lequel le système de production d'énergie électrique est utilisé.

A cet effet, l'invention propose un système de production d'énergie électrique selon la revendication 1. Des caractéristiques optionnelles sont définies aux revendications 2 à 16.

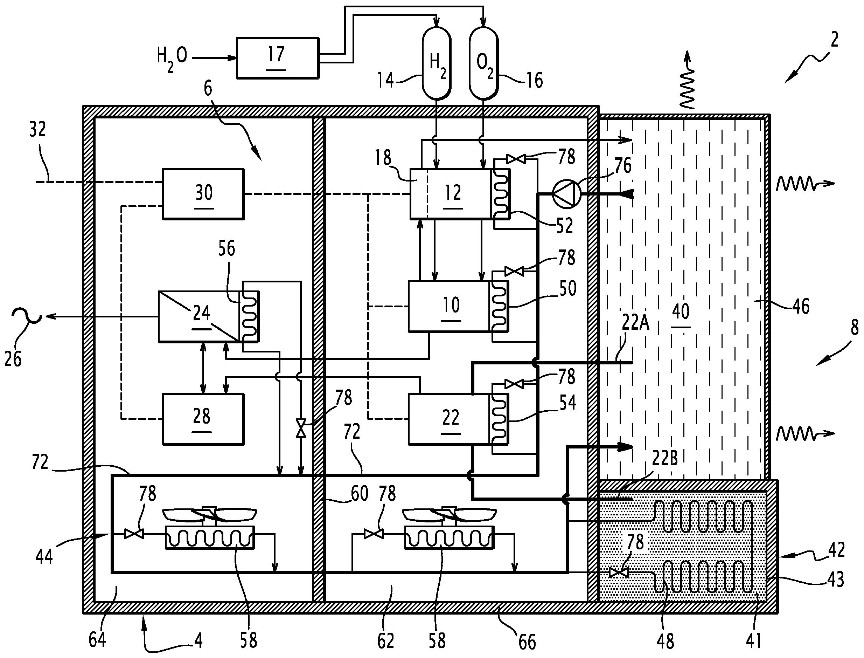

L'invention et ses avantages seront mieux compris à la lecture de la description qui va suivre, donnée uniquement à titre d'exemple non limitatif, et faite en référence à l'unique figure annexée illustrant schématiquement un système de production d'énergie électrique.

Le système de production d'énergie électrique 2 illustré sur la figure comprend une enceinte 4 étanche, un ensemble de production d'électricité 6 comprenant des équipements pour la production d'énergie électrique disposés à l'intérieur de l'enceinte 4, et un système de régulation thermique 8 pour réguler la température de l'ensemble de production d'électricité 6.

L'enceinte 4 est configurée pour être étanche aux fluides gazeux ou liquides. L'enceinte 4 délimite un volume interne fermé et étanche aux fluides

L'ensemble de production d'électricité 6 est disposé à l'intérieur de l'enceinte 4. Chaque équipement fonctionnel de l'ensemble de production d'électricité 6 est disposé à l'intérieur de l'enceinte 4.

L'ensemble de production d'électricité 6 comprend une pile à combustible 10 pour produire de l'énergie électrique par réaction d'oxydoréduction entre un comburant et un combustible. La pile à combustible 10 est disposée à l'intérieur de l'enceinte 4.

La pile à combustible 10 comprend au moins une cellule électrochimique, et de préférence plusieurs cellules électrochimiques empilées formant un empilement ou « stack » ou un ensemble de plusieurs empilements ou stack. Chaque cellule électrochimique est alimentée en combustible et en comburant et produit de l'énergie électrique. Les cellules électrochimiques d'un même empilement sont généralement reliées fluidiquement en parallèle et électriquement en série.

La pile à combustible 10 est par exemple une pile à combustible à membrane échangeuse de protons ou « PEMFC » (acronyme de « Proton Exchange Membrane Fuel Cell » en anglais) ou une pile à combustible à oxyde solide ou « SOFC » (acronyme de « Solid Oxyde Fuel Cell » en anglais).

L'ensemble de production d'électricité 6 comprend un système d'alimentation pour alimenter la pile à combustible 10 en combustible et en comburant, comprenant une unité de gestion de fluide 12, une source de combustible 14 et une source de comburant 16.

L'unité de gestion de fluide 12 configurée pour alimenter la pile à combustible 10 en comburant et en combustible à partir de la source de combustible 14 et de la source de comburant 16 du système de production d'énergie électrique 2. L'unité de gestion de fluide 12 est disposée à l'intérieur de l'enceinte 4.

Dans l'exemple illustré, la pile à combustible 10 est une pile à combustible dihydrogène/dioxygène. Le combustible est du dihydrogène (H₂) et le comburant est du dioxygène (O₂). En fonctionnement, la pile à combustible 6 produit de l'eau comme effluent résultant de la réaction d'oxydoréduction.

La source de combustible 14 est un réservoir de dihydrogène disposé à l'extérieur de l'enceinte 4. La source de comburant 16 est un réservoir de dioxygène disposé à l'extérieur de l'enceinte 4. En variante, La source de combustible 14 est disposée à l'intérieur de l'enceinte 4 et/ou la source de comburant 16 est disposée à l'intérieur de l'enceinte 4. Encore en variante, la source de combustible et/ou la source de comburant comprend un stockage partiel à l'intérieur de l'enceinte complété par un stockage partiel à l'extérieur de l'enceinte. De préférence, une source d'azote est également disponible à l'intérieur ou/et à l'extérieur de l'enceinte.

En option, le système de production d'électricité 2 comprend un générateur d'hydrogène 17 permettant d'alimenter la source de combustible 14 et éventuellement la source de comburant 16. Un tel générateur d'hydrogène 17 est par exemple un électrolyseur alimenté en eau et fournissant en sortie du dihydrogène et du dioxygène. Le générateur hydrogène est disposé à l'intérieur ou à l'extérieur de l'enceinte 4.

L'unité de gestion de fluide 12 relie fluidiquement la pile à combustible 10 à la source de combustible 14 et à la source de comburant 16 et commande les débits de combustible et de comburant alimentant la pile à combustible 10.

L'unité de gestion de fluide 12 comprend un module de traitement 18 configuré pour traiter les effluents de la pile à combustible 10. Le module de traitement 18 est en particulier configuré pour transformer du dihydrogène et dioxygène présent dans les effluents en eau. Du dihydrogène et du dioxygène peuvent être présents dans les effluents en faible quantité pendant le fonctionnement de la pile à combustible 10, ou en quantité sensiblement plus importante en cas de purge de la pile à combustible 10, par exemple en vue d'un inertage de la pile à combustible 10.

En option, le module de traitement 18 est configuré pour mesurer la concentration de dioxygène et la concentration de dihydrogène dans l'enceinte 4 pour prévenir tout risque d'explosion, et déclencher une alerte et une action de mitigation du risque (p.ex. inertage de l'enceinte à l'azote, activation d'un système de recombinage, aspersion d'eau ou inhibiteur de combustion) le cas échéant.

L'ensemble de production d'électricité 6 comprend un module thermoélectrique 22 configuré pour générer de l'énergie électrique du fait d'une différence de température. Le module thermoélectrique 22 est disposé à l'intérieur de l'enceinte 4.

Le module thermoélectrique 22 utilise par exemple l'effet Seebeck selon lequel une différence de potentiel électrique apparaît entre deux extrémités d'un conducteur électrique portées à des températures différentes.

L'ensemble de production d'électricité 6 comprend un convertisseur de puissance 24 recevant l'énergie électrique produite par la pile à combustible 10. Le convertisseur de puissance 24 est disposé à l'intérieur de l'enceinte 4.

Le convertisseur de puissance 24 est prévu pour fournir et recevoir de l'énergie électrique à un réseau électrique 26 en interface avec le système de production d'énergie électrique 2.

L'ensemble de production d'électricité 6 comprend un dispositif de stockage d'énergie électrique 28 pour stocker de l'énergie électrique. Le dispositif de stockage d'énergie électrique 28 est disposé à l'intérieur de l'enceinte 4.

Le dispositif de stockage d'énergie électrique 28 est par exemple une batterie ou une supercapacité ou un système mécanique du type volant d'inertie. Le dispositif de stockage d'énergie électrique 28 reçoit de l'électricité fournie par le réseau électrique 26 et/ou de l'électricité produite par la pile à combustible 10 et/ou de l'électricité produite par le module thermoélectrique 22, directement ou indirectement via le convertisseur de puissance 24.

Le dispositif de stockage d'énergie électrique 28 est relié électriquement au convertisseur de puissance 24 pour recevoir de l'énergie électrique du convertisseur de puissance 24 ou pour fournir de l'énergie électrique au convertisseur de puissance 24.

L'ensemble de production d'électricité 6 comprend une unité de commande 30 reliée aux autres équipements de l'ensemble de production d'électricité 6 pour les commander. L'unité de commande 30 est disposée à l'intérieur de l'enceinte 4. Elle est reliée à l'extérieur de l'enceinte 4 par une ligne de communication externe 32. L'unité de commande est reliée aux équipements qu'elle commande par des lignes de communication interne représentées en pointillés sur la Figure.

Le système de régulation thermique 8 est configuré pour réguler la température de l'ensemble de production d'électricité 6 disposé à l'intérieur de l'enceinte 4. Le système de régulation thermique 8 est configuré pour réguler la température des différents équipements individuellement. Le système de régulation thermique 8 est ici également configuré pour réguler la température du volume interne de l'enceinte 4 dans lequel se trouve l'ensemble de production d'électricité 6.

Le système de régulation thermique 8 comprend une source froide 40, une source chaude 42 et un circuit de fluide caloporteur 44 pour la circulation d'un fluide caloporteur.

La source froide 40 est disposée à l'extérieur de l'enceinte 4. La source froide 40 est formée par un réservoir 46 contenant le fluide caloporteur. Le réservoir de fluide caloporteur 46 présente un volume important, par exemple de l'ordre de 15 Nm3 d'eau pour une capacité de stockage thermique de 400kWh. Pour illustration, cette puissance thermique correspond à l'énergie thermique cumulée produite pendant 5 heures pour un système de production d'électricité de 100kWe. Le réservoir de fluide caloporteur 46 présente ainsi une grande inertie thermique et sa température varie lentement, en fonction de la température de l'environnement extérieur. Le réservoir de fluide caloporteur 46 est démunie de couche isolante, pour un échange de chaleur entre le fluide caloporteur présente dans le réservoir de fluide caloporteur 46 et l'environnement extérieur.

Le fluide caloporteur est par exemple de l'eau déionisée et éventuellement additivée d'un composant permettant d'abaisser le point de congélation et/ou d'inhiber les phénomènes de corrosion. Dans ce cas, l'unité de gestion de fluide 12 est par exemple configurée pour réinjecter l'eau récupérée des effluents de la pile à combustible vers la source froide 40.

La source chaude 42 est un dispositif de stockage de chaleur à matériau à changement de phase (MCP ou PCM pour « Phase Change Material » en anglais) permettant de stocker de la chaleur latente par changement de phase du matériau à changement de phase, et de la restituer.

Le matériau à changement de phase possède une chaleur latente élevée et permet de stocker une grande quantité la chaleur sous forme de chaleur latente sans élévation de température, et à la restituer également à température quasi constante. La température reste constante jusqu'à ce que la totalité du matériau à changement de phase change de phase

Le matériau à changement de phase est de préférence à changement de phase solide-liquide. Il est propre à stocker de la chaleur en se liquéfiant et à restituer de la chaleur en se solidifiant. Ces matériaux à changement de phase utilisés dans le cadre de cette application sont par exemple mais pas uniquement des paraffines encapsulées présentant des caractéristiques de température de changement de phase comprise de préférence entre 70 et 90°C et de chaleur latente supérieure à 50 kJ/kg permettant d'atteindre des densités de puissance calorifique supérieures à 50 kWh/Nm3.

La source chaude 42 comprend une enveloppe 43 contenant le matériau à changement de phase 41. L'enveloppe 43 est isolante thermiquement pour limiter les échanges thermiques entre le matériau à changement de phase 41 et l'extérieur et limiter les pertes de chaleur.

Le circuit de fluide caloporteur 44 est relié à la source froide 40. Dans le cas présent, le circuit de fluide caloporteur 44 s'alimente dans la source froide 40.

Le circuit de fluide caloporteur 44 comprend un échangeur de source chaude 48 disposé dans la source chaude 42 pour un échange de chaleur entre le matériau à changement de phase et le fluide caloporteur circulant dans l'échangeur de source chaude 48. En variante, le fluide caloporteur circule directement dans le réservoir 42 contenant le matériau à changement de phase 41 et échange directement avec celui-ci.

Le circuit de fluide caloporteur 44 est configuré pour la régulation thermique individuelle au moins de certains des équipements de l'ensemble de production d'électricité 6.

Le circuit de fluide caloporteur 44 alimente en fluide caloporteur un échangeur thermique individuel de chaque équipement dont la température est régulée individuellement.

Le circuit de fluide caloporteur 44 alimente un échangeur thermique de pile à combustible 50 pour la régulation thermique individuelle de la pile à combustible par échange thermique entre la pile à combustible 10 et le fluide caloporteur.

L'échangeur thermique de pile à combustible 10 est représenté schématiquement. De manière classique, l'échangeur thermique de pile à combustible 50 comprend des canalisations de circulation du fluide caloporteur s'étendant dans l'empilement de cellules électrochimiques, en particulier dans des plaques séparatrices séparant les cellules électrochimiques.

Le circuit de fluide caloporteur 44 alimente un échangeur thermique d'unité de gestion de fluide 52 pour la régulation thermique individuelle de l'unité de gestion de fluide 12 par échange thermique entre l'unité de gestion de fluide 12 et le fluide caloporteur.

Le circuit de fluide caloporteur 44 alimente un échangeur thermique de module thermoélectrique 54 pour la régulation thermique individuelle du module thermoélectrique 22 par échange thermique entre le module thermoélectrique 22 et le fluide caloporteur.

Le circuit de fluide caloporteur 44 alimente un échangeur thermique de convertisseur de puissance 56 pour la régulation thermique individuelle du convertisseur de puissance 56 par échange thermique entre le convertisseur de puissance 26 et le fluide caloporteur.

Le circuit de fluide caloporteur 44 est configuré pour la régulation thermique du volume interne de l'enceinte 4.

A cet effet, il comprend au moins un échangeur thermique d'enceinte 58 pour la régulation thermique du volume interne de l'enceinte par échange thermique entre l'air contenu dans l'enceinte et le fluide caloporteur. Le circuit de fluide caloporteur 44 comprend ici deux échangeurs thermiques d'enceinte 58.

L'enceinte 4 comprend une cloison interne 60 délimitant à l'intérieur de l'enceinte 4 un premier compartiment 62 et deuxième compartiment 64 séparés l'un de l'autre par la cloison interne 60. La cloison interne 60 est étanche aux fluides. L'enceinte 4 délimite un volume interne fermé et étanche aux fluides, L'enceinte 4 peut être inertée partiellement sans oxygène dans le compartiment 62.

Le module de traitement 18 de l'unité de gestion de fluide 12 est configuré pour traiter les effluents de la pile à combustible 10, en particulier configuré pour transformer du dihydrogène et dioxygène présent dans les effluents ou dans l'enceinte du compartiment 62 en eau qui peut être stockée ou transférée vers la source froide 40.

Un échangeur thermique d'enceinte 58 est disposé dans chacun du premier compartiment 62 et du deuxième compartiment 64.

L'unité de commande 30, le convertisseur de puissance 24 et le dispositif de stockage d'énergie électrique 26 sont disposés dans le premier compartiment 64. La pile à combustible 10, l'unité de gestion de fluide 12 (incluant le module de traitement 18) et le module thermoélectrique 22 sont disposés dans le deuxième compartiment 62.

L'enceinte 4 est entourée d'une couche isolante 66 pour isoler thermiquement l'enceinte 4 de l'environnement extérieur.

L'unité de commande 30 reçoit des signaux de mesure de température des différents équipements disposés à l'intérieur de l'enceinte 4, de l'air dans l'enceinte 4, de la source froide 40 et de la source chaude 42.

Dans l'exemple illustré, le circuit de fluide caloporteur 44 comprend une boucle principale 72 de circulation de fluide caloporteur sur laquelle chaque échangeur thermique se raccorde en parallèle. Le circuit de fluide caloporteur 44 comprend une pompe de circulation 76 pour faire circuler le fluide caloporteur dans la boucle principale 72 et des électrovannes 78 pilotées par l'unité de commande 30 commandant l'alimentation de chaque échangeur thermique individuellement. La boucle principale 72 s'alimente en fluide caloporteur dans la source froide 40 et débouche dans la source froide 40. D'autres schémas de circuit de fluide caloporteur sont possibles. Le sens de circulation du fluide caloporteur et l'ordre de passage du fluide caloporteur dans les échangeurs de chaleurs associés aux différents équipements peut être différent par construction ou par commande de l'unité de commande 30 en fonction des phases de fonctionnement de l'ensemble de production d'électricité 6, de l'état de chacun des équipements et des conditions d'environnement extérieur au système de production d'énergie électrique 2.

Le module thermoélectrique 22 est configuré pour produire de l'électricité du fait de la différence de température entre la source froide 40 et la source chaude 42. Il comprend une sonde froide 22A plongée dans la source froide 40 et une sonde chaude 22B plongée dans la source chaude 42.

En fonctionnement, lorsqu'il est nécessaire de refroidir un ou plusieurs équipements individuellement ou de refroidir le volume interne de l'enceinte, le circuit de fluide caloporteur 44 est commandé par l'unité de commande 30 pour faire circuler du fluide caloporteur de la source froide 40 vers le ou chaque échangeur thermique approprié.

Si le fluide caloporteur est à une température adéquate après avoir récupéré la chaleur dans les différents échangeurs thermiques dans l'enceinte 4, le circuit de fluide caloporteur 44 est commandé pour la circulation du fluide caloporteur ayant traversé le ou chaque échangeur de chaleur activé dans l'enceinte 4 vers la source chaude 42. Les calories prélevées par le fluide caloporteur dans les échangeurs thermiques sont fournies à la source chaude 42 pour leur stockage sous forme de chaleur latente dans la source chaude 42, en vue d'une utilisation ultérieure.

Lorsqu'il est nécessaire de réchauffer un ou plusieurs composants individuellement ou l'air dans l'enceinte, le circuit de fluide caloporteur 44 est commandé par l'unité de commande 30 pour faire circuler du fluide caloporteur dans la source chaude 42 puis vers le ou chaque échangeur thermique approprié pour apporter des calories à l'équipement associé ou pour réchauffer le volume interne de l'enceinte 4 dans son ensemble. Le fluide caloporteur est ensuite dirigé vers la source froide 40 pour son stockage.

Le système de production d'énergie électrique 2 est utilisable comme source d'énergie électrique de secours, pour suppléer à une source d'alimentation électrique principale (par ex. le réseau électrique 26) défaillante.

Le système de production d'énergie électrique 2 est propre à se maintenir en veille dans une phase inactive dans l'attente d'un démarrage, et à s'activer et à démarrer la production d'électricité par l'ensemble de production d'électricité 6 pour produire de l'énergie électrique en cas de défaillance de la source principale d'électricité.

Le système de production d'énergie électrique 2 en veille est propre à se maintenir de manière autonome dans des conditions appropriées au démarrage de l'ensemble de production d'électricité 6 (stockage d'énergie nécessaire au démarrage et/ou température).

Le système de production d'énergie électrique 2 comprenant des équipements de production d'électricité disposés dans une enceinte 4 étanche aux fluides permet d'isoler ces équipements de l'environnement extérieur pour assurer un démarrage et un fonctionnement fiables, y compris en cas de conditions fortement dégradées dans l'environnement extérieur. Les connexions fluidiques ou électriques vers l'extérieur (connexion électrique au réseau électrique, connexion électrique à la ligne de communication, connexions fluidiques aux sources de combustible et de comburant) sont réalisées de manière étanche.

Le système de régulation de température 8 permet de maintenir les équipements dans des plages de températures appropriées, que cela soit pendant une phase inactive pendant laquelle ces équipements ne fonctionnent pas mais leur intégrité doit être assurée, ou pendant une phase active pendant laquelle ces équipements fonctionnent.

La source chaude 42 et la source froide 40 sont dimensionnées pour stocker une quantité de frigories et une quantité de calories suffisantes pour une période d'inactivité de durée cumulée spécifiée et une période d'activité de durée cumulée spécifiée.

En fonctionnement continu, les équipements et leurs actionneurs sont alimentés en énergie électrique par la pile à combustible 10. Le système de production d'énergie électrique 2 est autonome pour sa propre alimentation en énergie électrique.

Le démarrage de l'ensemble de production d'énergie électrique nécessite un apport d'énergie initial, notamment un apport d'énergie électrique. De l'énergie est stockée dans le système de production d'énergie électrique, sous forme d'énergie électrique dans le dispositif de stockage d'énergie électrique 28 et sous forme d'énergie thermique dans les sources froide 40 et chaude 42. L'énergie thermique peut être convertie en énergie électrique par le module thermoélectrique 22.

Le dispositif de stockage d'énergie électrique 28 et le module thermoélectrique 22 permettent d'alimenter les actionneurs à commande électrique de la pile à combustible 10 nécessaires à son démarrage. La redondance de ces deux sources d'énergie électrique permet d'augmenter la fiabilité du démarrage de la pile à combustible 10. En variante, il est possible de prévoir seulement le dispositif de stockage d'énergie électrique 28 ou seulement le module thermoélectrique 22.

Le générateur d'hydrogène 17 est alimenté en énergie électrique par le réseau électrique 26 lorsque celui-ci n'est pas défaillant, pendant une période d'inactivité de la pile à combustible 10.

L'unité de commande 30 est programmée pour maintenir le système de production d'énergie électrique 2 dans des conditions appropriées au démarrage de la production d'énergie électrique de manière autonome, sans source d'énergie externe et de préférence sans échange de fluide avec l'extérieur

Selon un procédé de fonctionnement autonome, le système de production d'énergie électrique se maintient en capacité de démarrer de façon autonome en l'absence de source d'énergie externe.

En particulier, le système de production d'énergie électrique maintient le niveau d'énergie stocké dans ses dispositifs de stockage d'énergie (dispositif de stockage d'énergie électrique 28 et sources froide 40 et chaude 42) au-dessus d'un seuil d'énergie prédéterminé permettant de démarrer l'ensemble de production d'électricité à partir de l'énergie stockée dans les dispositif de stockage d'énergie, de manière autonome, en l'absence de source d'énergie électrique externe.

Le système de production d'énergie électrique contrôle à intervalles de temps régulier le niveau d'énergie des dispositifs de stockage d'énergie. En cas de niveau d'énergie inférieur au seuil prédéterminé, le système de production d'énergie électrique recharge en énergie au moins un dispositif de stockage d'énergie de manière à repasser au-dessus du seuil prédéterminé.

Le système de production d'énergie électrique contrôle à intervalles de temps régulier le niveau de charge du dispositif de stockage d'énergie électrique.

En cas de décharge du dispositif de stockage d'énergie électrique en deçà d'un seuil prédéterminé, le système de production d'énergie électrique recharge (complètement ou partiellement) le dispositif de stockage d'énergie électrique à partir d'une source d'énergie électrique externe, par exemple le réseau électrique 26, et/ou d'un dispositif de stockage d'énergie interne, par exemple à partir du dispositif de stockage d'énergie thermique formé par les sources froide 40 et chaude 42 et en utilisant le module thermoélectrique 22, de manière à repasser au-dessus du seuil prédéterminé.

Par ailleurs, dans l'attente d'un démarrage de l'ensemble de production d'énergie électrique, le système de production d'énergie électrique se maintient dans des conditions de températures appropriées pour le démarrage et le fonctionnement de l'ensemble de production d'énergie électrique, de préférence entre 0°C et 45°C pour les équipements les plus fragiles.

En cas de sollicitation et de démarrage de l'ensemble de production d'énergie électrique, le système de production d'énergie électrique se maintient en conditions de sécurité quelles que soient les conditions externes, sans échanges d'énergie ou de fluide avec l'extérieur.

Ceci est rendu possible notamment grâce aux moyens de stockage de combustible et de comburant (source de combustible 14 et de comburant 16) et aux sources d'énergie électrique internes (dispositif de stockage d'énergie électrique 28 et module thermoélectrique 22).

L'invention s'applique à un système de production d'énergie électrique utilisable pour l'alimentation électrique de secours de bâtiments sensibles tels qu'un hôpital, un centre de stockage de données (ou « data center » en anglais) ou une centrale nucléaire.

## Revendications

1. Système de production d'énergie électrique, comprenant une enceinte (4) étanche aux fluides,
- un ensemble de production d'électricité (6) disposé à l'intérieur de l'enceinte (4), l'ensemble de production d'électricité (6) comprenant une pile à combustible (10) pour produire de l'énergie électrique par réaction d'oxydoréduction entre un comburant et un combustible, un système d'alimentation (12, 14, 16) pour l'alimentation de la pile à combustible (10) en comburant et en combustible,
- un dispositif de stockage d'énergie électrique (28) disposé à l'intérieur de l'enceinte (4) pour fournir ou stocker de l'énergie électrique, et
- un convertisseur de puissance (24) disposé à l'intérieur de l'enceinte (4) et configuré pour échanger de l'énergie électrique avec la pile à combustible (10), le dispositif de stockage d'énergie électrique (28), un module thermoélectrique (22) et/ou un réseau électrique (26),
le système de production d'énergie électrique comprenant en outre un système de régulation thermique (8) comprenant une source froide (40), une source chaude (42) et un circuit de fluide caloporteur (44) configuré pour réguler la température de l'ensemble de production d'électricité (6) par échange de chaleur avec la source froide (40) et la source chaude (42).

2. Système selon la revendication 1, dans lequel la source froide (40) est disposée à l'extérieur de l'enceinte (4) et/ou la source chaude (42) est disposée à l'extérieur de l'enceinte (4).

3. Système selon la revendication 1 ou 2, dans lequel la source froide (40) est un réservoir de fluide caloporteur.

4. Système selon l'une quelconque des revendications précédentes, dans lequel la source chaude (42) est un dispositif de stockage de chaleur à matériau à changement de phase, le circuit de fluide caloporteur comprenant un échangeur de chaleur de source chaude (48) pour un échange thermique entre le fluide caloporteur et le matériau à changement de phase.

5. Système selon l'une quelconque des revendications précédentes, dans lequel le circuit de fluide caloporteur (44) comprend un échangeur de chaleur de pile à combustible (10) pour la régulation thermique individuelle de la pile à combustible (10).

6. Système selon l'une quelconque des revendications précédentes, dans lequel le système d'alimentation comprend une unité de gestion de fluide (12) configurée pour commander l'alimentation en comburant et en combustible de la pile à combustible (10).

7. Système selon la revendication 6, dans lequel le circuit de fluide caloporteur (44) comprend un échangeur de chaleur d'unité de gestion de fluide (52) pour la régulation thermique individuelle de l'unité de gestion de fluide (12).

8. Système selon l'une quelconque des revendications précédentes, dans lequel le circuit de fluide caloporteur (44) comprend un échangeur thermique de convertisseur de puissance (56) pour la régulation thermique individuelle du convertisseur de puissance (24).

9. Système selon l'une quelconque des revendications précédentes, dans lequel l'ensemble de production d'électricité (6) comprend un module thermoélectrique (22) configuré pour générer de l'énergie électrique du fait d'une différence de température.

10. Système selon la revendication 9, dans lequel le circuit de fluide caloporteur (44) comprend un échangeur de chaleur du module thermoélectrique (56) pour la régulation thermique individuelle du module thermoélectrique.

11. Système selon l'une quelconque des revendications précédentes, dans lequel le circuit de fluide caloporteur (44) comprend au moins un échangeur de chaleur d'enceinte (58) pour un échange de chaleur entre le volume interne de l'enceinte et le fluide caloporteur.

12. Système selon l'une quelconque des revendications précédentes, dans lequel l'enceinte (4) comprend au moins deux compartiments (62, 64) séparés, le système de régulation thermique comprenant un échangeur de chaleur d'enceinte (58) dans chaque compartiment pour un échange de chaleur entre le volume interne du compartiment et le fluide caloporteur.

13. Système selon la revendication 12, dans lequel la pile à combustible (10) et le système d'alimentation sont disposés dans un compartiment (62), et le convertisseur de puissance (24) et le dispositif de stockage d'énergie électrique (28) sont disposés dans l'autre compartiment (64).

14. Système selon l'une quelconque des revendications précédentes, dans lequel l'enceinte est enveloppée par une couche thermiquement isolante.

15. Système selon l'une quelconque des revendications précédentes, dans lequel la source chaude possède une enveloppe externe thermiquement isolante.

16. Système selon l'une quelconque des revendications précédentes, comprenant une source de combustible disposée à l'intérieur de l'enceinte et/ou à l'extérieur de l'enceinte et/ou une source de comburant disposée à l'intérieur de l'enceinte et/ou à l'extérieur de l'enceinte.

## Patentansprüche

1. System zum Erzeugen elektrischer Energie, aufweisend ein flüssigkeitsdichtes Gehäuse (4),
- eine Anordnung zum Erzeugen von Elektrizität (6), die innerhalb des Gehäuses (4) angeordnet ist, wobei die Anordnung zum Erzeugen von Elektrizität (6) eine Brennstoffzelle (10) zum Erzeugen elektrischer Energie mittels Redoxreaktion zwischen einem Sauerstoffträger und einem Brennstoff und ein Versorgungssystem (12, 14, 16) zum Versorgen der Brennstoffzelle (10) mit Sauerstoffträger und Brennstoff aufweist,
- eine Vorrichtung zum Speichern elektrischer Energie (28), die innerhalb des Gehäuses (4) zum Bereitstellen oder Speichern elektrischer Energie angeordnet ist, und
- einen Leistungswandler (24), der innerhalb des Gehäuses (4) angeordnet und der dazu eingerichtet ist, elektrische Energie mit der Brennstoffzelle (10), der Vorrichtung zum Speichern elektrischer Energie (28), einem thermoelektrischen Modul (22) und/oder einem elektrischen Netz (26) auszutauschen,
wobei das System zum Erzeugen elektrischer Energie ferner ein Wärmeregulationssystem (8), das eine Kältequelle (40), eine Wärmequelle (42) und einen Wärmeträgerflüssigkeitskreislauf (44), der dazu eingerichtet ist, die Temperatur der Anordnung zum Erzeugen von Elektrizität (6) mittels Wärmeaustauschs mit der Kältequelle (40) und der Wärmequelle (42) zu regeln, aufweist.

2. System gemäß Anspruch 1, wobei die Kältequelle (40) außerhalb des Gehäuses (4) angeordnet ist und/oder die Wärmequelle (42) außerhalb des Gehäuses (4) angeordnet ist.

3. System gemäß Anspruch 1 oder 2, wobei die Kältequelle (40) ein Wärmeträgerflüssigkeitsspeicher ist.

4. System gemäß einem der vorangehenden Ansprüche, wobei die Wärmequelle (42) eine Wärmespeichervorrichtung mit Phasenwechselmaterial ist, wobei der Wärmeträgerflüssigkeitskreislauf einen Wärmequellen-Wärmetauscher (48) aufweist für einen Wärmeaustausch zwischen der Wärmeträgerflüssigkeit und dem Phasenwechselmaterial.

5. System gemäß einem der vorangehenden Ansprüche, wobei der Wärmeträgerflüssigkeitskreislauf (44) einen Wärmetauscher der Brennstoffzelle (10) zur individuellen thermischen Regulierung der Brennstoffzelle (10) aufweist.

6. System gemäß einem der vorangehenden Ansprüche, wobei das Versorgungssystem eine Flüssigkeitsverwaltungseinheit (12) aufweist, die dazu eingerichtet ist, die Versorgung der Brennstoffzelle (10) mit Sauerstoffträger und mit Brennstoff zu steuern.

7. System gemäß einem Anspruch 6, wobei der Wärmeträgerflüssigkeitskreislauf (44) einen Wärmetauscher (52) der Flüssigkeitsverwaltungseinheit zur individuellen thermischen Regulation der Flüssigkeitsverwaltungseinheit (12) aufweist.

8. System gemäß einem der vorangehenden Ansprüche, wobei der Wärmeträgerflüssigkeitskreislauf (44) einen Leistungswandler-Wärmetauscher (56) zur individuellen thermischen Regulation des Leistungswandlers (24) aufweist.

9. System gemäß einem der vorangehenden Ansprüche, wobei die Anordnung zum Erzeugen von Elektrizität (6) ein thermoelektrisches Modul (22) aufweist, das dazu eingerichtet ist, elektrische Energie aufgrund einer Temperaturdifferenz zu erzeugen.

10. System gemäß Anspruch 9, wobei der Wärmeträgerflüssigkeitskreislauf (44) einen Wärmetauscher des thermoelektrischen Moduls (56) zur individuellen thermischen Regulation des thermoelektrischen Moduls aufweist.

11. System gemäß einem der vorangehenden Ansprüche, wobei der Wärmeträgerflüssigkeitskreislauf (44) mindestens einen Gehäuse-Wärmetauscher (58) zum Wärmetausch zwischen dem Innenvolumen des Gehäuses und der Wärmeträgerflüssigkeit aufweist.

12. System gemäß einem der vorangehenden Ansprüche, wobei das Gehäuse (4) mindestens zwei getrennte Kammern (62, 64) aufweist, wobei das Wärmeregulierungssystem einen Gehäuse-Wärmetauscher (58) in jeder Kammer zum Wärmeaustausch zwischen dem Innenvolumen der Kammer und der Wärmeträgerflüssigkeit aufweist.

13. System gemäß Anspruch 12, wobei die Brennstoffzelle (10) und das Versorgungssystem in einer Kammer (62) angeordnet sind und der Leistungswandler (24) und die Vorrichtung zum Speichern elektrischer Energie (28) in der anderen Kammer (64) angeordnet sind.

14. System gemäß einem der vorangehenden Ansprüche, wobei das Gehäuse von einer wärmeisolierenden Schicht umgeben ist.

15. System gemäß einem der vorangehenden Ansprüche, wobei die Wärmequelle einen wärmeisolierenden Außenmantel aufweist.

16. System gemäß einem der vorangehenden Ansprüche, aufweisend eine Brennstoffquelle, die innerhalb des Gehäuses und/oder außerhalb des Gehäuses angeordnet ist, und/oder eine Sauerstoffträgerquelle, die innerhalb des Gehäuses und/oder außerhalb des Gehäuses angeordnet ist.

## Claims

1. A electrical power generating system comprising a fluid-tight chamber (4),
- an electricity production assembly (6) arranged in the chamber, the electricity production assembly(6) comprising a fuel cell (10) for generating power by means of an oxidation-reduction reaction between an oxidizer and a fuel, and a supply system (12, 14, 16) for supplying oxidizer and fuel to the fuel cell (10),
- a power storage device (28) positioned inside the chamber (4) to provide or store electricity, and
- a power converter (24) positioned inside the chamber (4) and configured to exchange electricity with the fuel cell (10), a power storage device (28), a thermoelectric module (22) and/or a power grid (26),
the electrical power generating system also including a heat-control system (8) including a cold source (40) and a hot source (42), and a heat-transport fluid circuit (44) that is configured to control the temperature of the electricity production assembly (6) by exchanging heat with the cold source (40) and the hot source (42).

2. The system according to claim 1, wherein the cold source (40) is positioned outside the chamber (4) and/or the hot source (42) is positioned outside the chamber (4).

3. The system according to claim 1 or 2, wherein the cold source (40) is a heat transport fluid reservoir.

4. The system according to any one of the preceding claims, wherein the hot source (42) is a phase change material storage device, said heat transport fluid circuit comprising a hot source (48) heat exchanger for a heat exchange between the heat transport fluid and the phase change material.

5. The system according to any one of the preceding claims, wherein the heat transport fluid circuit (44) comprises a fuel cell (10) heat exchanger for the individual heat control of the fuel cell (10).

6. The system according to any one of the preceding claims, wherein the supply system comprises a fluid management unit (12) configured to control the supply of oxidizer and fuel to the fuel cell (10).

7. The system according to claim 6, wherein the heat transport fluid circuit (44) comprises a fluid management unit heat exchanger (52) for the individual heat control of the fluid management unit (12).

8. The system according to any one of the preceding claims , wherein the heat transport fluid circuit (44) comprises a power converter heat exchanger (56) for the individual heat control of the power converter (24).

9. The system according to any one of the preceding claims, wherein the electricity production assembly (6) comprises a thermoelectric module (22) configured to generate power due to a temperature difference.

10. The system according to claim 9, wherein the heat transport fluid circuit (44) comprises a heat exchanger of the thermoelectric module (56) for the individual heat control of the thermoelectric module.

11. The system according to any one of the preceding claims, wherein the heat transport fluid circuit (44) comprises at least one chamber heat exchanger (58) for exchanging heat between the inner volume of the chamber and the heat transport fluid.

12. The system according to any one of the preceding claims, wherein the chamber (4) comprises at least two separate compartments (62, 64), the heat control system comprising a chamber heat exchanger (58) in each compartment for exchanging heat between the inner volume of the compartment and a heat transport fluid.

13. The system according to claim 12, wherein the fuel cell (10) and the supply system are positioned in a compartment (62), and the power converter (24) and the energy storage system (28) in the other compartment (64).

14. The system according to any one of the preceding claims, wherein the chamber is surrounded by a thermally insulating layer.

15. The system according to any one of the preceding claims, wherein the hot source has a thermally insulating outer enclosure.

16. The system according to any one of the preceding claims, comprising a fuel source positioned inside the chamber and/or outside the chamber and/or an oxidizer source positioned inside the chamber and/or outside the chamber.
